# EUROPÄISCHE PATENTANMELDUNG

(11) **EP 1 357 774 A1**
(43) Veröffentlichungstag der Anmeldung: **29.10.2003**
(21) Anmeldenummer: 03450075.1
(22) Anmeldetag: 25.03.2003
(51) Int. Cl.: H05K 3/20, B29C 45/14, B29C 45/16

(54) **Verfahren zum Herstellen einer kunststoffumspritzen Leiterstruktur sowie elektrische Schaltungseinheit mit einer kunststoffumspritzten Leiterstruktur**

(30) Priorität: 26.04.2002 AT 6472002
(71) Anmelder: Pollmann Austria OHG, 3822 Karlstein/Thaya (AT)
(72) Erfinder: Fux, Reinhard, 3822 Karlstein an der Thaya (AT); Pollmann, Robert, 3822 Karlstein an der Thaya (AT)
(74) Vertreter: Sonn & Partner Patentanwälte

(57) **Zusammenfassung**

Die Erfindung betrifft ein Verfahren zum Herstellen einer kunststoffumspritzten Leiterstruktur (1) einer elektrischen Schaltungseinheit, wobei die Leiterstruktur (1) in eine Spritzgussform eingelegt und mindestens ein elektronischer Bauteil (10) od. dgl. an der Leiterstruktur (1) fixiert wird, und wobei in zumindest einem Kunststoffspritzvorgang die Leiterstruktur (1) samt dem zumindest einen elektronischen Bauteil (10) od. dgl. umspritzt wird. zum Schutz der elektronischen Bauteile (10) od. dgl. während des Kunststoffspritzvorganges ist erfindungsgemäß vorgesehen, dass zumindest ein elektronischer Bauteil (10) od. dgl. vor dem Kunststoffspritzvorgang mit einer Umhüllung (14) versehen wird. Die Umhüllung (14) kann aus zwei Teilen (14', 14") bestehen, wobei ein Teil (14') während eines Vorspritzvorganges hergestellt werden kann. Ebenso ist es möglich, die Umhüllung (14) einteilig und allenfalls mit einem Filmscharnier (17) auszubilden.

## Beschreibung

Die Erfindung betrifft ein Verfahren zum Herstellen einer kunststoffumspritzten Leiterstruktur einer elektrischen Schaltungseinheit, wobei die Leiterstruktur in eine Spritzgussform eingelegt und mindestens ein elektronischer Bauteil od. dgl. an der Leiterstruktur fixiert wird, und wobei in zumindest einem weiteren Kunststoffspritzvorgang die Leiterstruktur samt dem zumindest einen elektronischen Bauteil od. dgl. umspritzt wird.

Weiters betrifft die Erfindung eine elektrische Schaltungseinheit mit einer kunststoffumspritzten Leiterstruktur mit zumindest einem elektronischen Bauteil od. dgl.

Häufig werden Leiterstrukturen mit Kunststoff umspritzt, um dadurch eine Abdichtung gegenüber äußeren Einflüssen zu erzielen oder die Leiterstruktur elektrisch zu isolieren.

Zur Ummantelung von Leiterstrukturen ist es bekannt, die meist als Stanzgitter vorliegenden Leiterbahnen in eine Spritzgussform einzulegen und teilweise mit Kunststoff zu umspritzen. Allfällige metallische Stege, welche die Leiterbahnen in dem Stanzgitter miteinander verbinden, werden aufgetrennt. Ein Verfahren dieser Art ist beispielsweise aus der DE 44 07 508 A1 bekannt, bei welchem zur Schaffung eines besonders preiswerten Verfahrens zur Einbettung elektrischer Leiterbahnen in Kunststoff vorgesehen ist, das Stanzgitter in die Spritzgussform einzulegen, die Leiterbahnen durch Aufstecken eines elektrisch isolierenden Formteiles zu fixieren, die Stege des Stanzgitters zu trennen und danach den Kunststoff in die Spritzgussform einzuspritzen. Das Verfahren verwendet verlorene Formteile aus elektrisch isolierendem Werkstoff, insbesondere Formteile aus dem gleichen Kunststoff, mit welchem die Leiterbahnen umspritzt werden. Derartige vorgefertigte Formteile erfordern einen höheren Aufwand beim Einlegen in die Spritzgussform bzw. beim Anordnen der Formteile an den Leiterbahnen und sind darüber hinaus nicht exakt positionierbar.

Man ist bestrebt, nach dem vorliegenden Verfahren hergestellte Produkte mit möglichst wenig Steckkontakten bzw. Anschlüssen zu versehen, um dadurch die Dichtheitsprobleme zu reduzieren. Dies wird dadurch erreicht, dass ein Teil der Elektronik integriert wird, indem auf dem Leiterbahngebilde elektronische Bauelemente angeordnet werden.

Insbesondere bei Teilen für die Autoindustrie, wie beispielsweise Türschlössern oder Scheibenwischerantrieben, kann es durch Wassereintritt zu Fehlfunktionen kommen. Zur Vermeidung solcher Fehlfunktionen werden die elektronischen Bauteile bzw. andere empfindliche Komponenten mit Vergussmasse umhüllt oder bedeckt, wodurch jedoch nur eine unzureichende Dichtheit erzielt werden kann.

Zur Erhöhung der Dichtheit werden elektronische Bauteile od. dgl., welche mit der Leiterstruktur verbunden werden, ebenfalls mit Kunststoff umspritzt.

Beispielsweise beschreibt die DE 196 40 255 A ein Verfahren zur Herstellung eines elektronischen Moduls mit einer kunststoffumspritzten Leiterstruktur, bei dem die Leiterstruktur in zwei Phasen mit Kunststoff umspritzt wird, wobei bei einem ersten Spritzvorgang eine Nische zum Einlegen eines Teils, beispielsweise eines Dauermagnets, hergestellt wird und anschließend der Kunststoffkörper in einem zweiten Spritzvorgang endumspritzt wird. Durch die beim ersten Spritzvorgang hergestellte Nische zum Einlegen des Teils wird die gewünschte Position dieses Teils während der zweiten Spritzphase eingehalten.

Die DE 44 36 523 A1 zeigt ein Verfahren zur Herstellung eines elektronischen Geräts, wobei zur Positionierung und Verbindung elektronischer Bauteile in der Umspritzung an der Leiterstruktur Aussparungen verbleiben, in die die elektronischen Bauteile angeordnet werden können, so dass die während des zweiten Spritzgießvorganges einspritzende Kunststoffmasse die Bauteile nicht von der Leiterstruktur losreißen kann.

Aufgabe der vorliegenden Erfindung ist die Schaffung eines Verfahrens zum Herstellen kunststoffumspritzter Leiterstrukturen, mit dem ein höherer Grad der Integration der damit hergestellten Produkte erzielt werden kann und welches Verfahren darüber hinaus rasch und kostengünstig durchgeführt werden kann. Dabei sollen die erfindungsgemäßen elektrischen Schaltungseinheiten einen möglichst hohen Grad an Dichtheit aufweisen, und die darin enthaltenen elektronischen Bauelemente vor den während des Kunststoffspritzvorganges auftretenden thermischen und druckmäßigen Belastungen geschützt sein, so dass die Wahrscheinlichkeit von Fehlfunktionen reduziert werden kann.

In verfahrensmäßiger Hinsicht wird die erfindungsgemäße Aufgabe dadurch gelöst, dass zumindest ein elektronischer Bauteil od. dgl. vor dem Kunststoffspritzvorgang mit einer Umhüllung versehen wird. Durch die Umhüllung wird der elektronische Bauteil während dem Kunststoffspritzvorgang vor den auftretenden Temperaturen sowie Drucken geschützt und dadurch die Wahrscheinlichkeit von Fehlfunktionen der resultierenden elektrischen Schaltungseinheit deutlich reduziert. Andererseits können durch die Verwendung derartiger Umhüllungen beim Herstellungsverfahren auch empfindlichere elektronische Bauteile od. dgl. mitumspritzt werden und somit ein höherer Grad der Integration der damit hergestellten Produkte erzielt werden.
Nach diesem Verfahren hergestellte Produkte weisen eine besonders hohe Dichtheit auf, weshalb ein Einsatz, insbesondere in der Autoindustrie bevorzugt möglich ist.

Dabei kann die verwendete Umhüllung über einen oder mehrere elektronische Bauteile aufgeschoben oder über einen oder mehrere elektronische Bauteile od. dgl. und allenfalls über einen Teil der Leiterstruktur aufgesteckt werden. Dabei kann die Umhüllung auch als Halteelement für die Leiterstruktur dienen.

Gemäß einem weiteren Verfahrensmerkmal ist es möglich, dass in einem Vorspritzvorgang die Leiterstruktur teilweise umspritzt wird. Durch diese teilweise Umspritzung wird der Leiterstruktur eine für die nachfolgenden Kunststoffspritzvorgänge notwendige Stabilität verliehen.

Wird die Umhüllung mehrteilig oder einteilig mit einem Scharnier, vorzugsweise einem Filmscharnier ausgeführt, kann zumindest ein Teil der Umhüllung bereits während eines Vorspritzvorgangs hergestellt werden. Auf diese Weise kann während des Vorspritzvorgangs an jenen Stellen, an denen elektronische Bauteile od. dgl. vorgesehen werden, beispielsweise ein Unterteil der Umhüllung an der Leiterstruktur angespritzt werden, der beispielsweise eine Ausnehmung für den elektronischen Bauteil od. dgl. aufweist, in die der Bauteil eingelegt werden kann. Nach der Fixierung des elektronischen Bauteils od. dgl. an den Leiterbahnen wird ein entsprechend gestalteter Deckteil der Umhüllung auf diesen Unterteil aufgesteckt od. dgl. Auch eine einteilige Umhüllung kann in einem Vorspritzvorgang hergestellt werden, wenn diese mit einem Scharnier, vorzugsweise einem Filmscharnier versehen ist. Somit ist ein Einsetzen des elektronischen Bauteils od. dgl. in die Umhüllung und ein nachträgliches Schließen der Umhüllung möglich. Durch die Umhüllung des elektronischen Bauteils od. dgl. ist dieser nicht den Temperatur- und Druckeinwirkungen während nachfolgender Kunststoffspritzvorgänge ausgesetzt.

Gemäß einem weiteren Merkmal der Erfindung ist vorgesehen, dass die Umhüllung der elektronischen Bauteile od. dgl. während des zumindest einen Kunststoffspritzvorganges nur teilweise umspritzt wird. Auf diese Weise kann beispielsweise der Abstand vom umhüllten Bauteil zu einer externen Komponente geringer gehalten werden, oder bei Verwendung einer transparenten Umhüllung eine Kommunikation des Bauteils, beispielsweise einer Lichtquelle, nach außen ermöglicht werden.

Vorteilhafterweise wird zumindest ein elektronischer Bauteil od. dgl. nach dem Vorspritzvorgang an der Leiterstruktur fixiert, insbesondere angelötet. Alternativ dazu kann die Fixierung der Bauteile aber auch vor dem Vorspritzvorgang erfolgen.

Gemäß einem weiteren Merkmal der Erfindung ist vorgesehen, dass ein thermoplastischer Kunststoff zum Umspritzen der Leiterstruktur verwendet wird. Es ist die Verwendung sämtlicher technischer Thermoplaste denkbar. Der erforderliche Druck und die erforderliche Temperatur während des Spritzgussvorganges sollen für eine möglichst geringe Belastung der elektronischen Bauteile oder anderer Komponenten möglichst gering sein.

Gemäß einem weiteren Merkmal der Erfindung ist vorgesehen, dass beim Vorspritzvorgang zumindest ein Bauteil-Tragelement aus dem Kunststoff mitgespritzt wird, auf dem nach dem Erstarren zumindest ein elektronischer Bauteil od. dgl. positioniert wird. Durch die Herstellung des Tragelements während des Vorspritzvorganges können die elektronischen Bauteile oder andere Komponenten rasch und einfach an den entsprechenden Stellen der Leiterstrukturen angeordnet werden und danach allenfalls mit den Leiterbahnen, beispielsweise durch Löten, verbunden werden. Dadurch wird die Position der elektronischen Bauteile oder anderer Komponenten beim weiteren Kunststoffspritzvorgang gesichert, und diese Bauteile bzw. Komponenten können somit dicht und sicher ummantelt werden. Die Wahrscheinlichkeit eines Lösens der elektrischen Verbindungen zwischen Bauteil und Leiterbahn wird dadurch noch weiter reduziert.

Die während des Vorspritzvorganges mitgeformten Tragelemente können beispielsweise mit zumindest einem Schnappverbindungsteil oder als Presssitzelement geformt werden, in welche die elektronischen Bauteile od. dgl. mit möglichst geringem Aufwand eingelegt bzw. eingeschnappt werden können und in welchen die elektronischen Bauteile od. dgl. möglichst sicher gehalten werden, so dass ein Verrutschen während nachfolgender Kunststoffspritzvorgänge nicht möglich ist. Andererseits soll die Schnappverbindung bzw. das Presssitzelement keine unzulässigen Belastungen auf das Bauteil ausüben. Neben den genannten Konstruktionen sind auch einfache schalenförmige Ausbildungen der Tragelemente, in welche die elektronischen Bauteile od. dgl. eingelegt werden, möglich.

Allenfalls vorhandene mechanische Stütz- oder Verbindungsstege zwischen den Leiterbahnen der als Leiterbahn-Stanzteil ausgebildeten Leiterstruktur können nach dem allfälligen Vorspritzvorgang oder nach dem Fixieren allfälliger elektronischer Bauteile od. dgl. oder nach dem Anbringen zumindest von Teilen der Umhüllung nach an sich bekannten Methoden aufgetrennt bzw. entfernt.

Das erfindungsgemäße Verfahren kann noch rascher und kostengünstiger durchgeführt werden, wenn die elektronischen Bauteile über lokale elektrische Erwärmung benachbarter Leiterbahnteile der Leiterstruktur angelötet werden. Zu diesem Zweck müssen lediglich die Leiterbahnen in der Umgebung der gewünschten Lötstellen kontaktiert werden und ein entsprechender elektrischer Strom bzw. eine entsprechende elektrische Spannung angelegt werden. Der resultierende Strom ruft auf Grund des ohmschen Widerstands der Leiterbahn eine Verlustwärme hervor, welche das aufgebrachte Lötzinn zum Schmelzen bringt und eine sichere Lötverbindung zwischen Leiterbahn und Bauteilanschluss bewirkt. Ein derartiges Verfahren weist eine geringere thermische Belastung des Bauteiles auf als herkömmliche Lötverfahren und kann einfach automatisiert werden.

Wenn der Druck und bzw. oder die Temperatur der Kunststoffmasse in der Umgebung der zu umspritzenden Leiterstruktur während der Spritzvorgänge mit geeigneten Sensoren erfasst wird, kann eine Qualitätskontrolle durchgeführt werden. Im Falle des Erreichens unzulässig hoher Werte für den Druck oder die Temperatur während der Spritzvorgänge können die hergestellten Produkte ausgesondert, einer zusätzlichen Prüfung oder einer Vernichtung zugeführt werden.

Gelöst wird die erfindungsgemäße Aufgabe auch durch eine elektrische Schaltungseinheit mit einer kunststoffumspritzten Leiterstruktur mit zumindest einem elektronischen Bauteil od. dgl., wobei zumindest ein elektronischer Bauteil od. dgl. mit einer Umhüllung versehen ist, welche zumindest teilweise von dem für die Umspritzung verwendeten Kunststoff verschieden ist. Eine solche elektrische Schaltungseinheit ermöglicht durch die erfindungsgemäße Anordnung von Umhüllungen um die elektronischen Bauteile od. dgl. eine Integration auch besonders empfindlicher Bauteile in der umspritzten elektrischen Schaltungseinheit und reduziert andererseits die Fehleranfälligkeit der elektronischen Bauteile od. dgl. durch die Belastung während des Kunststoffspritzvorgangs. Beispielsweise können derartige elektrische Schaltungseinheiten in Türschlössern für Kraftfahrzeuge, welche immer den äußeren Witterungseinflüssen ausgesetzt sind, eingesetzt werden. Darüber hinaus sind solche Schaltungseinheiten sehr rasch und billig, insbesondere bei der Massenproduktion, herstellbar.

Dabei kann die Umhüllung zweiteilig ausgebildet sein, wobei die Teile der Umhüllung miteinander verbindbar sind. Die zu umhüllenden elektronischen Bauteile od. dgl. werden zwischen den Teilen der Umhüllung angeordnet und nach Verbindung der Teile optimal geschützt.

Zur Verbindung der Teile der Umhüllung weisen diese vorzugsweise Schnappverbindungselemente auf. Dadurch können die Teile der Umhüllung besonders rasch und einfach um die zu schützenden elektronischen Bauteile od. dgl. angeordnet werden.

Bei einer zweiteiligen Umhüllung kann ein Teil der Umhüllung aus dem für die Umspritzung verwendeten Kunststoff gebildet sein.

Ebenso ist es möglich, dass die Umhüllung einteilig ausgebildet ist und über den elektronischen Bauteil od. dgl. gestülpt wird.

Wenn die einteilige Ausführung der Umhüllung ein Scharnier, vorzugsweise ein Filmscharnier, aufweist, kann auch eine Anordnung des elektronischen Bauteils od. dgl. zwischen den beidseitig des Scharnier wegstehenden Umhüllungsteilen eingeschnappt werden.
Um die Umhüllung verschließen zu können, kann diese einen Verschluss, vorzugsweise einen Schnappverschluss, aufweisen.

Die Teile der Umhüllung lassen sich besonders rasch und einfach durch das Spritzgussverfahren herstellen, wenn diese durch einen Thermoplast gebildet sind.

Wenn zumindest Teile der Umhüllung aus temperaturbeständigem Kunststoff, vorzugsweise aus modifiziertem Polybutylenterephtalat gebildet sind, werden Beschädigungen dieser Teile der Umhüllung während des Anlötens der elektronischen Bauteile od. dgl. an den Leiterbahnen vermieden.

Wenn zumindest Teile der Umhüllung zumindest teilweise transparent ausgebildet sind, können an der Schaltungseinheit auch optoelektronische Bauteile angeordnet werden und dennoch eine Kommunikation nach außen ermöglicht werden.

Gemäß einem weiteren Merkmal der Erfindung ist vorgesehen, dass aus dem für die Umspritzung verwendeten Kunststoff zumindest ein Tragelement gebildet ist, welches zumindest einen elektronischen Bauteil od. dgl. trägt. Dadurch wird die Verbindung des elektronischen Bauelements mit den Leiterbahnen erleichtert, da diese beispielsweise während des Lötens nicht mehr gehalten werden müssen.

Gemäß einem weiteren Merkmal der Erfindung weist das Tragelement einen Schnappverbindungsteil auf. In diesen kann ein entsprechender elektronischer Bauteil od. dgl. rasch und einfach eingesetzt werden, wobei ein ausreichender Halt während der Umspritzung mit Kunststoff gewährleistet wird. Als Schnappverbindungsteile kommen beispielsweise widerhakenförmige Konstruktionen od. dgl. in Frage.

Alternativ dazu können Tragelemente auch als Presssitzelemente ausgebildet sein, in welche die elektronischen Bauteile od. dgl. eingeschoben oder eingedrückt werden. Darüber hinaus sind auch Tragelemente in Form von Schalen oder Ähnlichem, in welche die elektronischen Bauteile oder andere Komponenten eingelegt werden, möglich.

Vorteilhafterweise ist das zumindest eine elektronische Bauteil od. dgl. als temperaturbeständiges Bauteil od. dgl. ausgebildet, so dass während eines Kunststoffspritzgussvorganges keine thermische Überbelastung des Bauteils eintritt.

Die Erfindung wird an Hand der Zeichnungen, welche ein Ausführungsbeispiel der Erfindung zeigen, noch weiter erläutert. Darin zeigen:
Fig. 1 eine Leiterstruktur in Draufsicht,
Fig. 2 die Leiterstruktur nach einem Biegevorgang in perspektivischer Ansicht,
Fig. 3 eine perspektivische Ansicht der Leiterstruktur nach einem allfälligen Vorspritzvorgang,
Fig. 4 eine perspektivische Ansicht der Leiterstruktur mit angelöteten elektronischen Bauteilen,
Fig. 5 das Detail V aus Fig. 4 in vergrößerter Darstellung,
Fig. 6 eine perspektivische Ansicht auf die Leiterstruktur mit verschieden ausgeführten Umhüllungen vor deren Anordnung über den elektronischen Bauteilen,
Fig. 7 eine perspektivische Ansicht auf die Leiterstruktur nach dem Aufsetzen der Umhüllung,
Fig. 8 eine perspektivische Ansicht auf die elektrische Schaltungseinheit nach einem Kunststoffspritzvorgang,
Fig. 9 eine perspektivische Ansicht auf eine einteilige Ausführungsform einer Umhüllung,
Fig. 10 eine perspektivische Ansicht auf eine zweiteilige Ausführungsform einer Umhüllung, und
Fig. 11 und Fig. 12 zwei Ausführungsvarianten von Bauteiltragelementen im Querschnitt in vergrößerter Darstellung.

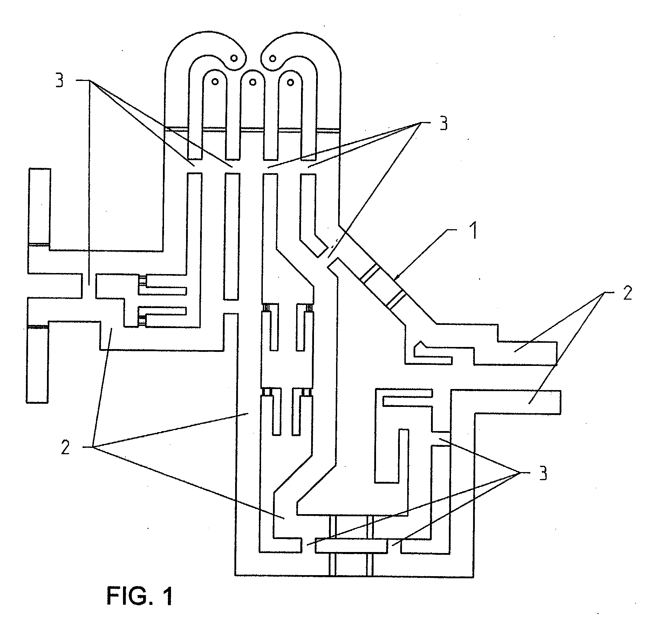

Fig. 1 zeigt die Draufsicht auf eine Leiterstruktur 1, welche vorzugsweise durch Stanzen hergestellt wird. Die Leiterstruktur 1 umfasst Leiterbahnen 2 sowie mechanische Stützoder Verbindungsstege 3, welche die Leiterbahnen 2 zusammenhalten.

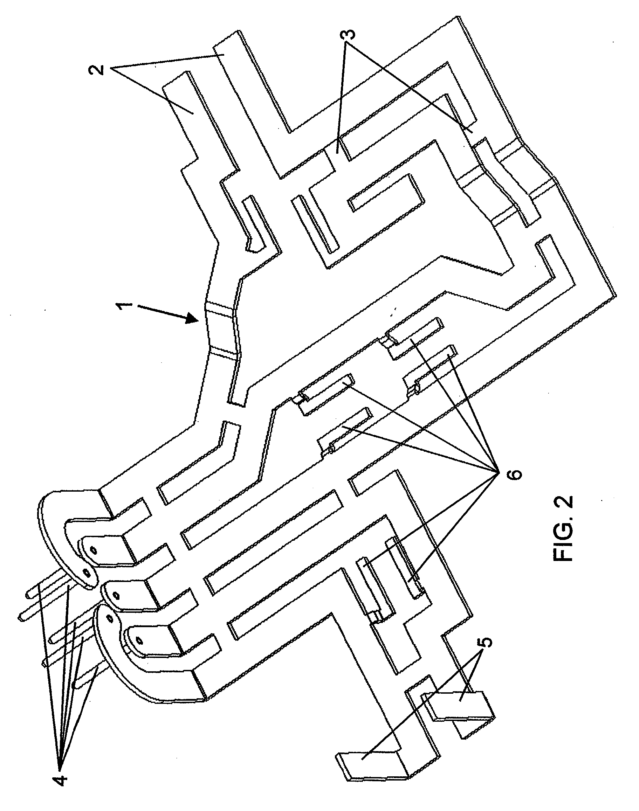

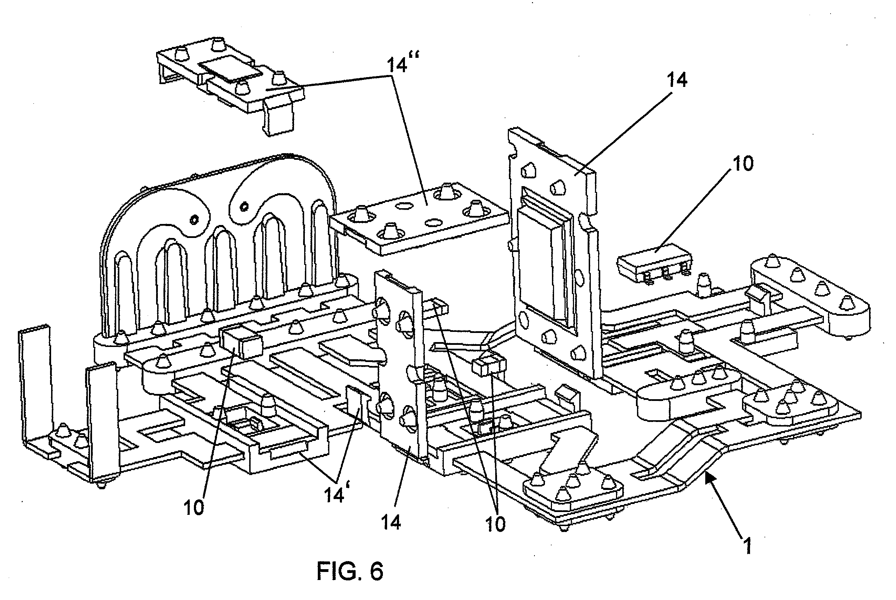

Fig. 2 zeigt die Leiterstruktur 1 nach einem Biegevorgang, durch welchen die Leiterbahnen 2 an die entsprechenden räumlichen Erfordernisse angepasst werden können. Durch das Biegen können auch allfällige Stecker vorbereitet werden, indem beispielsweise Steckerkontakte 4 mit den Leiterbahnen 2 verbunden werden. Ebenso können durch Biegen der Leiterbahnen 2 Lötfahnen 5 od. dgl. gebildet werden. Solche Lötfahnen 5 oder Steckkontakte 4 ragen aus dem fertig hergestellten und kunststoffummantelten Produkt und dienen zum Anschluss entsprechender Komponenten oder beispielsweise der Versorgungsspannung von außen. Weiters können Positionierungselemente 6 für elektronische Bauteile od. dgl. (10 in Fig. 6 bis 8) vorgesehen werden, welche dazu dienen, dass die Bauteile in Bezug auf die Ebene der Leiterstruktur 1 symmetrisch angeordnet werden können, sodass nach dem Umspritzen oberhalb und unterhalb des Bauteils 10 gleiche Kunststoffdicken resultieren. Die in Fig. 2 dargestellte Leiterstruktur 1 wird in eine Spritzgussform eingelegt und an bestimmten Stellen, welche nicht umspritzt werden, durch Stempel od. dgl. gehalten.

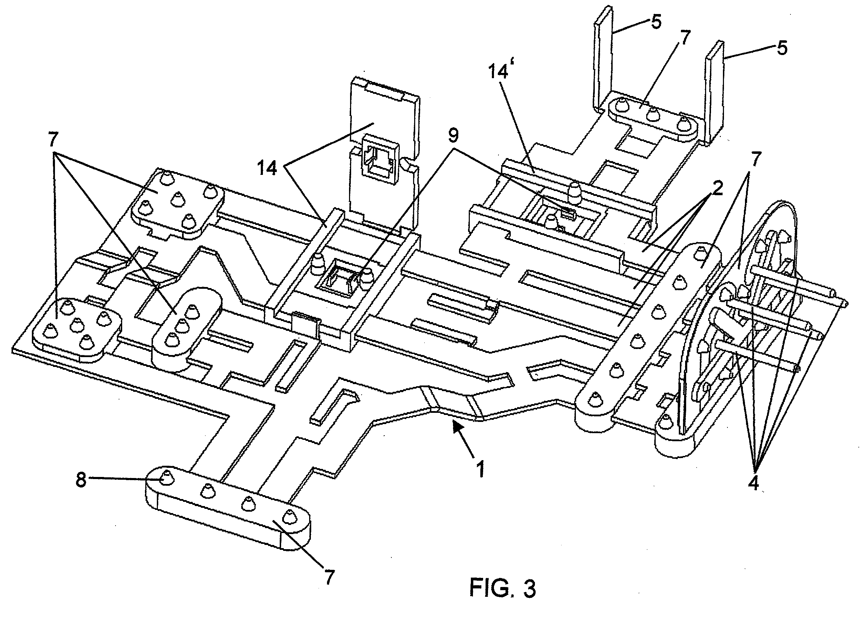

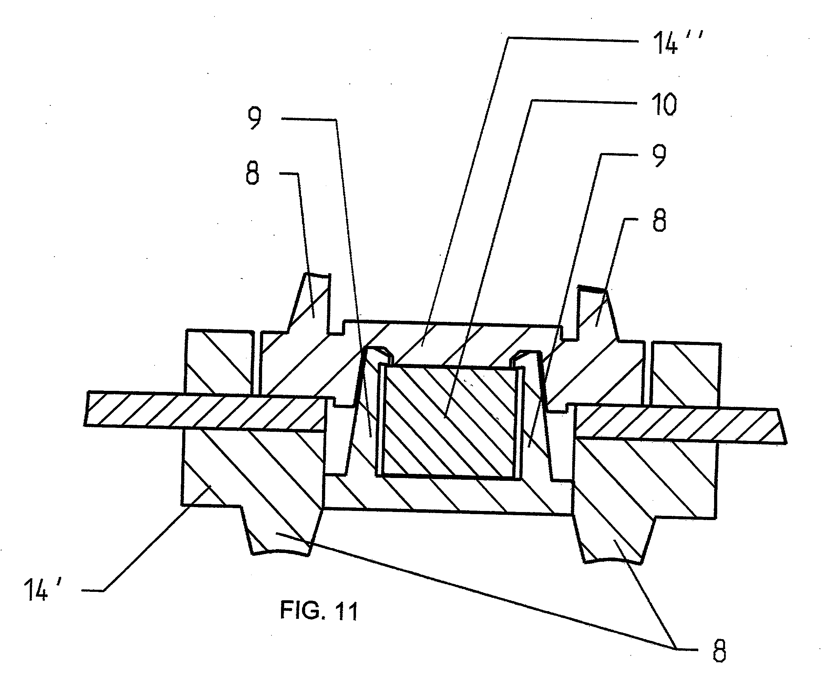

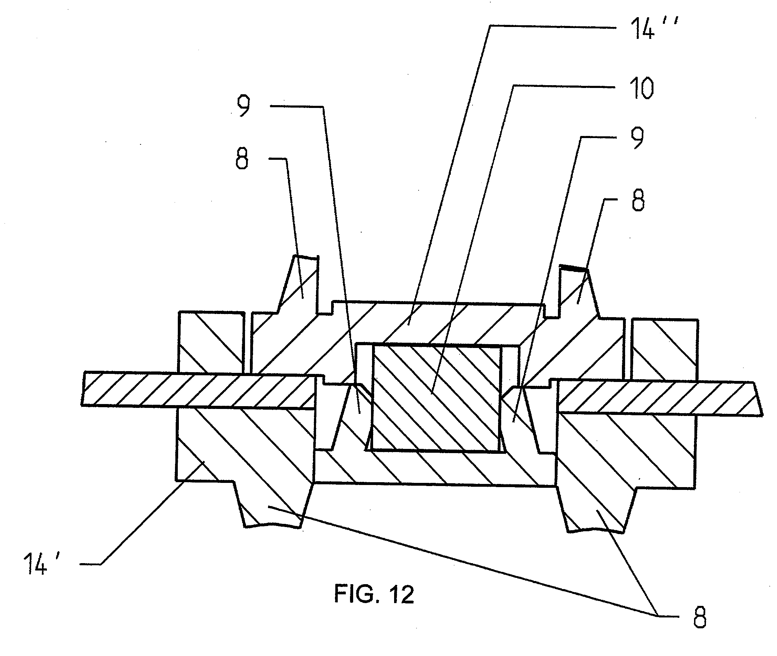

Nach einem allfälligen Vorspritzvorgang resultiert eine Leiterstruktur 1 entsprechend der Fig. 3. Dabei sind einzelne Regionen bereits mit Kunststoff 7 umspritzt. Der Kunststoff 7 kann an der Ober- und Unterseite Noppen 8 od. dgl. aufweisen, welche die Leiterstruktur 1 für den nächsten Spritzgussvorgang in Abstand von der Spritzgussform halten. An Stelle der dargestellten Noppen 8 können verschiedenartige Ausbildungen als Abstandhalter vorgesehen sein, mit welchen ein Abstand zwischen Gussform und Leiterstruktur 1 erzielt wird. Die durch den Kunststoff 7 gebildeten Teile bieten der Leiterstruktur 1 einen besseren Halt und können allfällige Tragelemente 9 für die anzuordnenden elektronischen Bauteile 10 od. dgl. (siehe Fig. 11 und 12) enthalten.

Ein derartiger Vorspritzvorgang ist jedoch nicht zwingend erforderlich. Wenn an Stellen, wo elektronische Bauteile od. dgl. umhüllt werden sollen, können auch entsprechend gestaltete Teile 14' der Umhüllung so angeordnet werden, dass sie neben der Umhüllungsfunktion für den elektronischen Bauteil od. dgl. auch eine gewisse Haltefunktion für die Leiterbahnen 2 der Leiterstruktur 1 ausüben.

Die mechanischen Stütz- oder Verbindungsstege 3 können nach dem Vorspritzvorgang oder nach dem Fixieren als allfälliger elektronischer Bauteil od. dgl. oder nach dem Anbringen zumindest von Teilen 14' der Umhüllung getrennt werden, da die Leiterbahnen 2 untereinander durch die Teile mit umspritztem Kunststoff 7 bzw. den Teilen 14' der Umhüllung 14 gehalten werden.

Für die Spritzvorgänge werden vorteilhafterweise Thermoplaste verwendet. Beispielsweise kann Polybuten (PBT) eingesetzt werden, welches allenfalls mit Glasfaser z.B. zu 20 % vermischt werden kann. Dabei treten üblicherweise Werkzeugtemperaturen von 70°C bis 100 °C, Massetemperaturen von 275°C bis 300 °C bei einem Spritzdruck von 800 bar bis 1600 bar auf. Neben Polybuten können sämtliche technische Thermoplaste verwendet werden.

Erfindungsgemäß kann beim allfälligen Vorspritzvorgang auch der Teil 14' der Umhüllung 14 für die elektronischen Bauteile od. dgl. hergestellt werden. Im dargestellten Beispiel wird der Teil 14' der Umhüllung 14 um die gewünschte Platzierung eines elektronischen Bauelements und um die dort angeordneten Leiterbahnen 2 angespritzt. Auch eine einteilige Umhüllung 14 kann in einem Vorspritzvorgang hergestellt werden, wenn diese mit einem Scharnier, vorzugsweise einem Filmscharnier versehen ist. Eine solche Konstruktion ermöglicht das Einsetzen eines elektronischen Bauteils od. dgl. in die Umhüllung 14 und ein nachträgliches Schließen der Umhüllung 14.

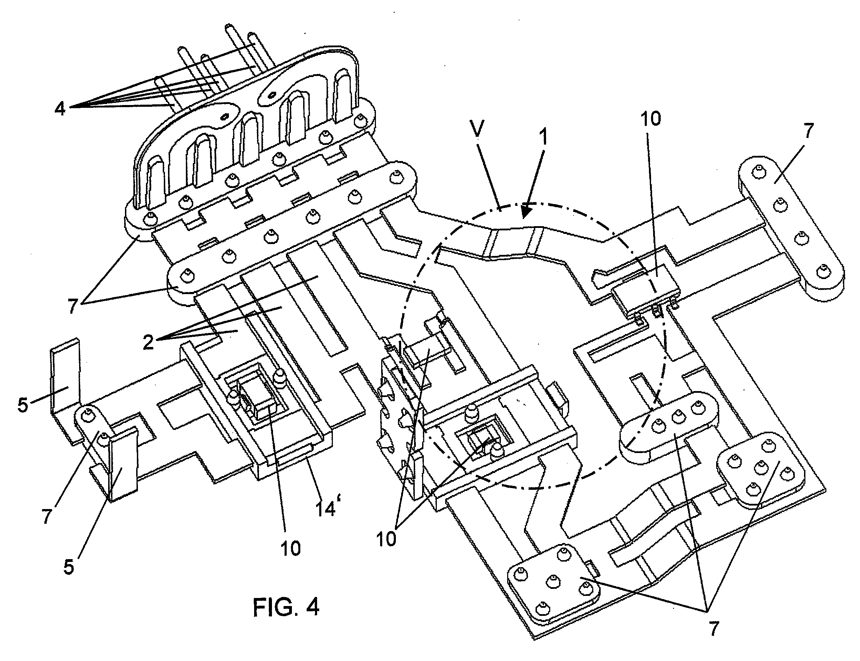

Fig. 4 zeigt die Leiterstruktur 1 mit bereits angeordneten elektronischen Bauteilen 10 od. dgl., welche vorzugsweise nach einem Vorspritzvorgang angeordnet werden. Die elektronischen Bauteile 10 od. dgl. können in herkömmlicher Technologie oder in Form von SMD-Bauteilen (Surface mounted device) vorliegen. Anstelle von elektronischen Bauteilen 10 können auch andere elektrische, elektromechanische oder mechanische Komponenten angeordnet werden. Die elektronischen Bauteile 10 od. dgl. werden an den dafür vorgesehenen Stellen mit den Leiterbahnen 2 vorzugsweise durch Löten verbunden.

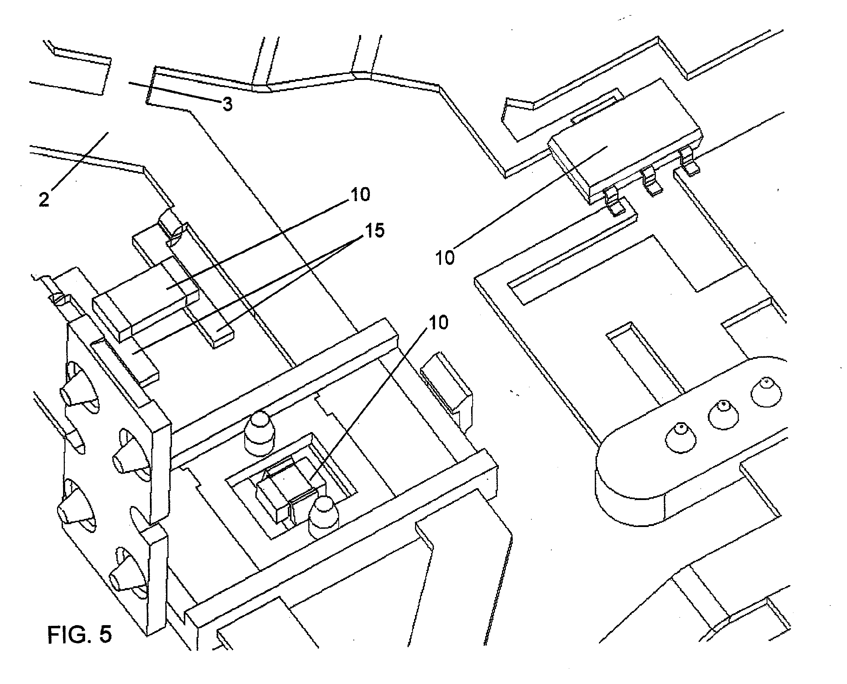

Wie in Fig. 5, welche das Detail V aus Fig. 4 in vergrößerter Darstellung zeigt, besser ersichtlich, sind die Leiterbahnen 2 an jenen Stellen, an denen elektronische Bauteile 10 od. dgl. vorgesehen werden sollen, besonders gestaltet. Da der Kunststoff nach dem Spritzvorgang während des Erstarrens eine Volumsänderung erfährt, übt dieser auf die umspritzten Leiterbahnen 2 aber auch auf die elektronischen Bauteile 10 od. dgl. eine Kraft aus. Um zu verhindern, dass die elektronischen Bauteile 10 von den Leiterbahnen 2 gelöst werden, sind diese an den Verbindungsstellen zu den elektronischen Bauteilen 10 od. dgl. elastisch ausgeführt. Dies kann beispielsweise durch Leiterbahnstücke 15 erfolgen, dessen Ende frei ist, so dass eine gewisse Elastizität zulässig ist. Natürlich können auch andere Konstruktionen vorgesehen sein, welche dem während der Erstarrung des Kunststoffes resultierenden Schwund bis zu einem gewissen Grad folgen können.

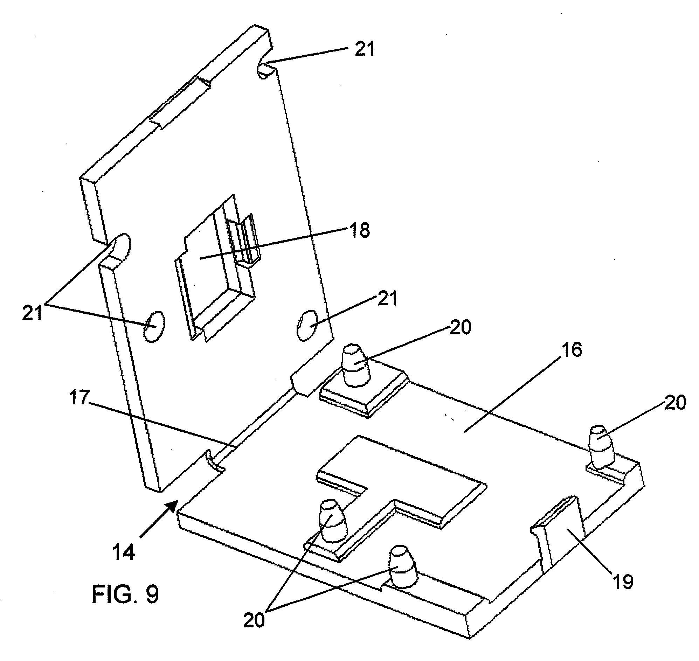

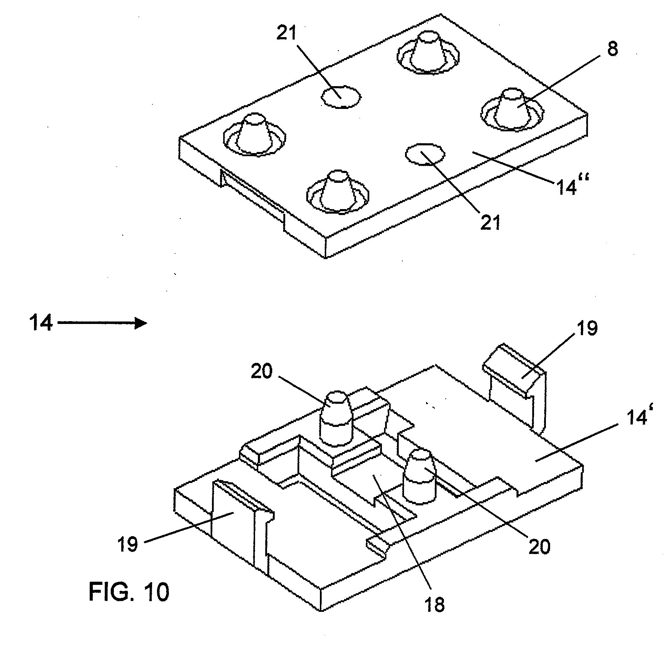

Fig. 6 zeigt die Leiterbahnstruktur 1 mit daran befestigten elektronischen Bauteilen 10 od. dgl., die bereits von Teilen der Umhüllungen 14 umgeben sind. Dabei sind einteilige Umhüllungen 14 als auch zweiteilige Umhüllungen 14, welche aus einem Unterteil 14' und einem Oberteil 14" bestehen, dargestellt. Details dieser Umhüllungen 14 werden in den Fig. 9 und 10 näher beschrieben. Die Umhüllungen 14 werden um die elektronischen Bauteile 10 od. dgl. angeordnet und danach die gesamte Leiterstruktur 1 in die Kunststoffspritzform eingelegt und zumindest einem Kunststoffspritzvorgang ausgesetzt.

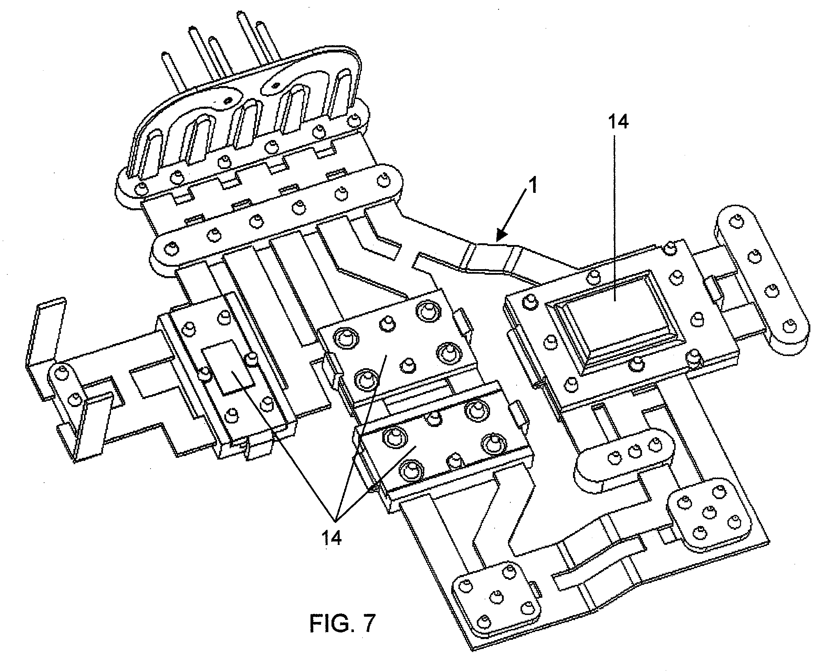

Fig. 7 zeigt die Leiterstruktur 1, bei der die elektronischen Bauteile 10 od. dgl. bereits mit den Umhüllungen 14 versehen sind.

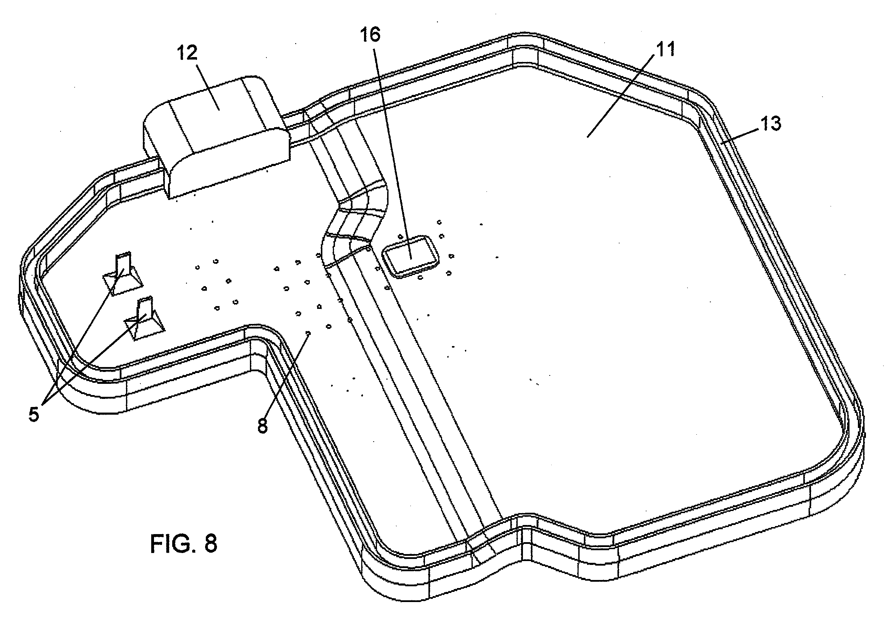

Fig. 8 zeigt eine perspektivische Ansicht auf die Leiterstruktur 1 nach einem Kunststoffspritzvorgang, wodurch ein kompaktes Gehäuse bzw. ein Teil davon gebildet wird. Gemäß dieser Ausführungsform wird durch den Kunststoffspritzvorgang ein Mantel 11 aus Kunststoff gebildet, welcher auch gleichzeitig ein Steckergehäuse 12 beinhaltet, in dem die Steckkontakte 4, welche mit den entsprechenden Leiterbahnen 2 verbunden sind, enthalten sind. Wenn ein Bauteil 10, z.B. ein SMD-Bauteil direkt auf die Leiterbahnen 2 aufgelegt und an diese angelötet werden, wird in der Spritzgussform über diesem Bauteil 10 eine Ausbuchtung vorgesehen, sodass die Dicke des Kunststoffes auch ober dem Bauteil 10 ausreichend groß ist. Es bildet sich somit auf dem fertigen Gehäuse eine Erhöhung 10'. Die dargestellte elektrische Schaltungseinheit kann als Komponente eines Gehäuses verwendet werden, weshalb im Kunststoffmantel 11 eine umlaufende Nut 13 für die Anordnung einer Dichtung (nicht dargestellt) vorgesehen sein kann. Der entsprechende gegenüberliegende Gehäuseteil (nicht dargestellt) kann allfällige weitere Komponenten für die elektrische Schaltungseinheit enthalten, welche beispielsweise mit den Lötfahnen 5 verbunden werden können. Für manche Anwendungen kann es auch sinnvoll oder notwendig sein, dass die Umhüllungen 14 der elektronischen Bauteile od. dgl. beim Kunststoffspritzvorgang nur teilweise umspritzt werden, so dass ein Fenster 16 frei bleibt. Dadurch kann einerseits erreicht werden, dass der Abstand vom elektronischen Bauteil 10, beispielsweise einem Hallsensor, zu einer externen Komponente möglichst gering ist. Andererseits kann bei Verwendung eines transparenten Materials für die Umhüllung 14 bei optoelektronischen Bauelementen 10 eine Kommunikation nach außen gewährleistet werden.

Fig. 9 zeigt eine perspektivische Ansicht einer einteiligen Umhüllung 14, welche ein Filmscharnier 17 aufweist. Der elektronische Bauteil 10 od. dgl. wird in eine allfällige Ausbuchtung 18 eingesetzt und danach die Umhüllung 14 durch Zusammenklappen geschlossen. Damit die Umhüllung 14 verschlossen bleibt, kann ein Verschluss 19, vorzugsweise ein Schnappverschluss, vorgesehen sein. Zur ordnungsgemäßen Schließung der Umhüllung 14 können weiters Verbindungselemente beispielsweise in Form von Bolzen 20 und zugehörigen Löchern 21 angeordnet sein. Die Umhüllung 14 kann aus thermoplastischem Material vorzugsweise im Spritzgussverfahren hergestellt sein, wobei Materialien mit besonders hoher Temperaturbeständigkeit, beispielsweise modifiziertes Polybutylenterephtalat (PBT), besonders geeignet ist, da dieser Kunststoff während des allfälligen Lötverfahrens zur Verbindung der elektronischen Bauteile 10 od. dgl. mit den Leiterbahnen 2 nicht beschädigt wird.

Fig. 10 zeigt eine perspektivische Ansicht einer zweiteiligen Ausführungsform einer Umhüllung 14, bei der der Unterteil 14' eine Ausnehmung 18 für den elektrischen Bauteil 10 od. dgl. aufweist und zur Verbindung mit einem Oberteil 14" mit Verbindungselementen in Form von Bolzen 20 und Löchern 21 sowie Schnappverschlüssen 19 versehen ist. An der Außenseite der Umhüllung 14 sind Noppen 8 angeordnet, welche als Abstandhalter zur Spritzgussform für den Kunststoffspritzvorgang dienen.

Die Fig. 11 und 12 zeigen Schnittbilder durch die Leiterstruktur 1 an einer Stelle eines elektronischen Bauteils 10 od. dgl., wobei in einem Vorspritzvorgang Teile aus Kunststoff 7 hergestellt werden, welche Tragelemente 9 für die elektronischen Bauteile 10 enthalten. Mit Hilfe der Tragelemente 9 im Kunststoff 7 können die elektronischen Bauteile 10 od. dgl. einfacher platziert werden. Das jeweilige Tragelement 9 für das elektronische Bauteil 10 kann entsprechend Fig. 7 mit einem Schnappverbindungsteil ausgebildet sein, in den das elektronische Bauteil 10 od. dgl. eingesteckt und von dem es selbständig ehalten wird. Dadurch wird ein sicherer Halt des Bauteils 10 od. dgl. gewährleistet. Das Anlöten der Anschlüsse des elektronischen Bauteils 10 an die entsprechenden Leiterbahnen 2 wird dadurch ebenfalls erleichtert. Vorteilhafterweise wird das Lötverfahren mittels elektrischen Stromes, der durch die Leiterbahnen 2 in der unmittelbaren Umgebung der Anschlüsse des elektronischen Bauteils 10 geleitet wird und somit die Leiterbahnen 2 in dieser Region aufwärmt, durchgeführt. Ebenso können aber auch herkömmliche Lötverfahren angewandt werden.

Fig. 12 zeigt eine alternative Ausführungsform der Tragelemente 9 in Form eines Presssitzelementes, in welches der elektronische Bauteil 10 od. dgl. eingepresst wird. Das Tragelement kann darüber hinaus beliebige Gestalt aufweisen.

Um während der Kunststoffspritzvorgänge den Druck und bzw. oder die Temperatur der Kunststoffmasse in der Umgebung der zu umspritzenden Leiterstruktur 1 erfassen zu können, können entsprechende Sensoren (nicht dargestellt) an geigneten Stellen der Leiterstruktur 1 oder der Spritzgussform angeordnet sein. Die erfassten Daten können zur Qualitätskontrolle eingesetzt werden.

Mit dem erfindungsgemäßen Verfahren kann eine elektrische Schaltungseinheit hergestellt werden, welche einen hohen Grad an Integration aufweist, indem zumindest ein Teil der elektronischen Bauteile zusammen mit den Leiterbahnen mit einem Kunststoff, insbesondere einem thermoplastischen Kunststoff, umspritzt wird. Dadurch müssen nur noch die unbedingt notwendigen Steckkontakte oder Lötfahnen zur Verbindung mit der Versorgungsspannung und andere Schnittstellen nach außen geführt werden, welche eine Fehlerquelle in Bezug auf die Dichtheit aufweisen. Somit kann eine derartige elektrische Schaltungseinheit besonders dicht und somit geschützt vor äußeren Witterungseinflüssen hergestellt werden. Insbesondere für die Massenproduktion eignet sich das Spritzgussverfahren, welches besonders rasch und kostengünstig durchgeführt werden kann.

Auf diese Weise können beispielsweise elektronische Türschlösser für Kraftfahrzeuge oder Scheibenwischerantriebe für Kraftfahrzeuge und vieles mehr hergestellt werden. Durch das erfindungsgemäße Verfahren entfällt das nachträgliche Anordnen von elektronischen Bauteilen, welche eine zusätzliche Fehlerquelle darstellt. Gegenüber herkömmlichen Verfahren, bei welchen die außerhalb der Kunststoffummantelung angeordneten elektronischen Bauteile mit einer entsprechenden Vergussmasse umhüllt wurden, weist das vorliegende Verfahren bzw. damit hergestellte Produkte einen höheren Grad an Dichtheit auf. Dadurch wird die Fehlerquote derartig hergestellter elektrischer Schaltungseinheiten deutlich reduziert.

Auf Grund der sehr raschen Spritzgussvorgänge und der Umhüllungen müssen die elektronischen Bauteile, welche umspritzt werden, keine außergewöhnlich hohen Temperatur- und Druckgrenzwerte aufweisen, weshalb keine besonders hohen Anforderungen an dieselben gestellt werden müssen.

## Patentansprüche

1. Verfahren zum Herstellen einer kunststoffumspritzten Leiterstruktur einer elektrischen Schaltungseinheit, wobei die Leiterstruktur in eine Spritzgussform eingelegt und mindestens ein elektronischer Bauteil an der Leiterstruktur fixiert wird, und wobei in zumindest einem Kunststoffspritzvorgang die Leiterstruktur samt dem zumindest einen elektronischen Bauteil umspritzt wird, **dadurch gekennzeichnet, dass** zumindest ein elektronischer Bauteil vor dem Kunststoffspritzvorgang mit einer Umhüllung versehen wird.

2. Verfahren nach Anspruch 1, **dadurch gekennzeichnet, dass** die Umhüllung über zumindest einen elektronischen Bauteil aufgeschoben wird.

3. Verfahren nach Anspruch 1, **dadurch gekennzeichnet, dass** die Umhüllung über zumindest einen elektronischen Bauteil und allenfalls über einen Teil der Leiterstruktur aufgesteckt wird.

4. Verfahren nach einem der Ansprüche 1 bis 3, **dadurch gekennzeichnet, dass** in einem Vorspritzvorgang die Leiterstruktur teilweise umspritzt wird.

5. Verfahren nach einem der Ansprüche 1 bis 4, **dadurch gekennzeichnet, dass** in einem Vorspritzvorgang zumindest ein Teil der Umhüllung für die elektronischen Bauteile hergestellt wird.

6. Verfahren nach einem der Ansprüche 1 bis 5, **dadurch gekennzeichnet, dass** die Umhüllung während des zumindest einen Kunststoffspritzvorganges nur teilweise umspritzt wird.

7. Verfahren nach einem der Ansprüche 4 bis 6, **dadurch gekennzeichnet, dass** zumindest ein elektronischer Bauteil nach dem Vorspritzvorgang an der Leiterstruktur fixiert wird.

8. Verfahren nach einem der Ansprüche 1 bis 7, **dadurch gekennzeichnet, dass** ein thermoplastischer Kunststoff zum Umspritzen der Leiterstruktur verwendet wird.

9. Verfahren nach einem der Ansprüche 4 bis 8, **dadurch gekennzeichnet, dass** beim Vorspritzvorgang zumindest ein Bauteil-Tragelement aus dem Kunststoff mitgespritzt wird, auf dem nach dem Erstarren zumindest ein elektronischer Bauteil positioniert wird.

10. Verfahren nach Anspruch 9, **dadurch gekennzeichnet, dass** das Tragelement mit zumindest einem Schnappverbindungsteil geformt wird.

11. Verfahren nach Anspruche 9, **dadurch gekennzeichnet, dass** das Tragelement als Presssitzelement geformt wird.

12. Verfahren nach einem der Ansprüche 1 bis 11, **dadurch gekennzeichnet, dass** nach dem allfälligen Vorspritzvorgang oder nach dem Fixieren allfälliger elektronischer Bauteile oder nach dem Anbringen zumindest von Teilen der Umhüllung mechanische Stützoder Verbindungsstege zwischen Leiterbahnen der als Leiterbahn-Stanzteil ausgebildeten Leiterstruktur aufgetrennt werden.

13. Verfahren nach einem der Ansprüche 1 bis 12, **dadurch gekennzeichnet, dass** die elektronischen Bauteile über lokale elektrische Erwärmung der benachbarten Leiterteile der Leiterstruktur angelötet werden.

14. Verfahren nach einem der Ansprüche 1 bis 13, **dadurch gekennzeichnet, dass** der Druck und bzw. oder die Temperatur der Kunststoffmasse in der Umgebung der zu umspritzenden Leiterstruktur während der Spritzvorgänge erfasst wird.

15. Elektrische Schaltungseinheit mit einer kunststoffumspritzten Leiterstruktur (2) mit zumindest einem elektronischen Bauteil (10), **dadurch gekennzeichnet, dass** zumindest ein elektronischer Bauteil (10) mit einer Umhüllung (14) versehen ist, welche zumindest teilweise von dem für die Umspritzung verwendeten Kunststoff (7) verschieden ist .

16. Schaltungseinheit nach Anspruch 15, **dadurch gekennzeichnet, dass** die Umhüllung (14) zweiteilig ausgebildet ist, und dass die Teile (14', 14") der Umhüllung (14) miteinander verbindbar sind.

17. Schaltungseinheit nach Anspruch 16, **dadurch gekennzeichnet, dass** die Teile (14', 14") der Umhüllung (14) Schnappverbindungselemente (19) aufweisen.

18. Schaltungseinheit nach Anspruch 16 oder 17, **dadurch gekennzeichnet, dass** ein Teil (14') der Umhüllung (14) aus dem für die Umspritzung verwendeten Kunststoff (7) gebildet ist.

19. Schaltungseinheit nach Anspruch 15, **dadurch gekennzeichnet, dass** die Umhüllung (14) einteilig ausgebildet ist.

20. Schaltungseinheit nach Anspruch 19, **dadurch gekennzeichnet, dass** die Umhüllung (14) ein Scharnier, vorzugsweise ein Filmscharnier (17) aufweist.

21. Schaltungseinheit nach Anspruch 20, **dadurch gekennzeichnet, dass** die Umhüllung (14) einen Verschluss, vorzugsweise einen Schnappverschluss (19) aufweist.

22. Schaltungseinheit nach einem der Ansprüche 15 bis 21, **dadurch gekennzeichnet, dass** zumindest Teile (14', 14") der Umhüllung (14) durch einen Thermoplast gebildet sind.

23. Schaltungseinheit nach einem der Ansprüche 15 bis 21, **dadurch gekennzeichnet, dass** zumindest Teile (14', 14") der Umhüllung (14) aus temperaturbeständigem Kunststoff, vorzugsweise aus modifiziertem Polybutylenterephtalat (PBT) gebildet sind.

24. Schaltungseinheit nach einem der Ansprüche 15 bis 23, **dadurch gekennzeichnet, dass** zumindest Teile (14', 14") der Umhüllung (14) zumindest teilweise transparent ausgebildet sind.

25. Schaltungseinheit nach einem der Ansprüche 15 bis 24, **dadurch gekennzeichnet, dass** aus dem für die Umspritzung verwendeten Kunststoff (7) zumindest ein Tragelement (9) gebildet ist, welches zumindest einen elektronischen Bauteil (10) trägt.

26. Schaltungseinheit nach Anspruch 25, **dadurch gekennzeichnet, dass** das Tragelement (9) einen Schnappverbindungsteil aufweist.

27. Schaltungseinheit nach Anspruch 25, **dadurch gekennzeichnet, dass** das Tragelement (9) als Presssitzelement ausgebildet ist.

28. Schaltungseinheit nach einem der Ansprüche 15 bis 27, **dadurch gekennzeichnet, dass** der zumindest eine elektronische Bauteil (10) als temperaturbeständiger Bauteil ausgeführt ist.
